# EUROPEAN PATENT SPECIFICATION

(11) **EP 0 336 266 B1**
(45) Date of publication and mention of the grant of the patent: **28.02.1996**
(21) Application number: 89105471.0
(22) Date of filing: 28.03.1989
(51) Int. Cl.: C08L 63/10, C08L 33/00, C08F 299/00, H05K 1/00

(54) **Electrical laminate produced by using special thermosetting resin compostions**
Electrischer Schichtstoff hergestellt durch den Verwendung von spezieler wärmhärtbaren Harzzusammensetzungen
Stratifié électrique fabriqué en utilisant une compositions de résine thermodurcisable spéciale

(30) Priority: 04.04.1988 JP 82574/88
(43) Date of publication of application: 11.10.1989
(73) Proprietor: Hitachi Chemical Co., Ltd., Shinjuku-ku, Tokyo 160 (JP)
(72) Inventor: Hanawa, Akinori, Shimotsuma-shi Ibaraki-ken (JP); Yokota, Mitsuo, Yuki-shi Ibaraki-ken (JP); Shimizu, Akira, Shimodate-shi Ibaraki-ken (JP); Tanaka, Kazuyuki, Hitachi-shi Ibaraki-ken (JP); Yamashita, Yukihiko, Hitachi-shi Ibaraki-ken (JP)
(74) Representative: Strehl Schübel-Hopf Groening & Partner

(56) References cited:
- US-A- 3 524 901
- PATENT ABSTRACTS OF JAPAN, vol. 9, no. 222 (C-302)[1945], 9th September 1985
- DATABASE WPIL, accession no. 84-130947 [21], Derwent Publications Ltd, London,GB

## Description

### BACKGROUND OF THE INVENTION

### (a) Field of the Invention

The present invention relates to electrical laminates (insulating laminate, copper clad laminate for printed circuit board, etc.) having excellent flame resistance, electrical properties, and punching quality, produced by using a special thermosetting resin composition.

### (b) Description of the Related Art

The recent progress of semiconductor technology and advancement of electronic apparatus have been increasing the demand for printed boards and, at the same time, the higher quality of printed circuits has been required. At the present time, in the production of electrical laminates, combination of a glass base material with an epoxy resin, combination of a paper base material with a phenolic resin or an unsaturated polyester resin, or the like are generally employed.

Particularly, in the production of paper base material-phenolic resin- or paper base material-unsaturated polyester resin-laminates and -printed circuit boards, which are used mainly for consumer appliances, improvement of flame resistance has been contrived for safety's sake and, in concurrence, improvement of size accuracy and decrease of punching temperature are also contrived for facilitating automatic mounting of parts by insertion.

The conventional flameproofing by introduction of halogen atoms in the resin skeleton and addition of various kinds of flame retardants has a disadvantage in that sufficient flame resistance cannot be attained without the decrease of the other necessary properties such as heat resistance, chemical resistance, electrical properties, etc.

Also, the conventional methods of improving punching quality by adding plasticizers or by endowing the resin skeleton with flexibility cause the decreases of heat resistance, chemical resistance, moisture resistance, etc.

In Japanese Patent Application Publication No. 60-17340 disclosed is a method wherein a resin obtained by reacting a halogenized bisphenol A diglycidyl ether with a dimer acid is used as the flame retardant for thermosetting resins, and in Japanese Patent Application Publication No. 60-45061 disclosed is a method of using a resin varnish consisting of a dicyclopentadiene polyester resin, an acrylic ester of diglycidyl ether or glycidyl ester through a dibasic acid of 4 to 36 carbon atoms, and an organic peroxide. However, these conventional methods failed in providing laminates satisfying all requirements concurrently, that is, good flame resistance, improvement of the punching quality at low temperature, moisture resistance, chemical resistance, and excellent electrical properties.

### SUMMARY OF THE INVENTION

An object of the present invention is to provide an electrical laminate having good flame resistance and excellent punching quality at low temperature and having concurrently satisfactory heat resistance, moisture resistance, chemical resistance, and electrical properties.

According to the present invention, there is provided an electrical lamitate produced by impregnating a base material whith a thermosetting resin composition comprising (A) a dibasic acid modified epoxy (meth)acrylate resin obtained by reacting a bromine-containing epoxy resin with a dimer of an unsaturated C₁₆ - C₁₈ - fatty acid followed by further reacting with acrylic acid or methacrylic acid, (B) a thermosetting resin having an unsaturated group in its side chains, the unsaturated group being copolymerizable with the resin (A), and (C) a polymerizable monomer.

This electrical laminate excels in flame resistance, heat resistance, moisture resistance, chemical resistance, electrical properties, and low temperature punching quality.

### DESCRIPTION OF THE PREFERRED EMBODIMENT

In the present invention, the term of bromine-containing epoxy resin means an epoxy compound having at least two epoxy groups in one molecule and containing bromine in the resin. Particularly preferred bromine-containing epoxy resin to be used in the present invention has a bromine content of not less than 35 % by weight. The bromine-containing epoxy resin may be either one consisting only of a brominated epoxy resin having bromine in its molecule skeleton or a mixture of a brominated epoxy resin and a non-brominated epoxy resin. The preferred brominated epoxy resin to be used in the present invention has a bromine content of 15 to 55 % by weight. Some illustrative examples of such a brominated epoxy resin include epoxy resins obtained by polycondensing a bromine-containing polyhydric phenol, such as tetrabromobisphenol A, tetrabromobisphenol F, and a brominated novolak resin, with epichlorohydrin. Among these, the preferred are those of tetrabromobisphenol A type having a bromine content of 15 to 55 % by weight. Examples of commercially available brominated epoxy resins which may be used in the present invention include SUMI-EPOXY ESB-340, ESB-400, ESB-500, and ESB-700 produced by Sumitomo Chemical Co., Ltd., DER-542, DER-511, and DER-580 produced by Dow Chemical Co., Ltd., and EPIKOTE 1045, 1046, 1050, and DX248 produced by Yuka Shell Kabushiki Kaisha. These brominated epoxy resins may be mixed with non-brominated epoxy resins to adjust the bromine content to a predetermined amount. In such a case, the resulting bromine-containing epoxy resin contains preferably not less than 25 % by weight of brominated epoxy resin.

As the dimer of an unsaturated fatty acid of 16 to 18 carbon atoms particularly preferred is dimer acid. Preferred examples of commercially available dibasic acids which may be used in the present invention include ENPOL 1022 and ENPOL 1024 produced by Emery Co., Ltd. and VERSADYME 216, 228, and 288 produced by Henkel Hakusui Kabushiki Kaisha, which have a dimer acid content of 30 to 97 %, preferably 50 to 97 %, and an acid value of 180 to 200. The ratio of the amount of the dibasic acid used to the amount of the epoxy resin used is not particularly restricted, but it is preferable to react 0.01 to 0.9 equivalent, more preferably 0.1 to 0.9 equivalent of dibasic acid with one equivalent of epoxy resin.

Various kinds of methods may be employed for the reaction of the bromine-containing epoxy resin with the dimer of the C₁₆-C₁₈ unsaturated fatty acid (also termed "dibasic acid"), and, generally, the bromine-containing epoxy resin and the dibasic acid are reacted at 70 to 150 °C, in the presence of an organic amine catalyst, such as triethylamine, benzyldimethylamine, tri-n-butylamine, N,N-dimethylaniline, and N,N-dimethylcyclohexylamine, or an alkaline metal hydroxide catalyst, such as sodium hydroxide and lithium hydroxide. In this reaction, at need, a solvent, such as toluene, ethyl acetate, and methyl ethyl ketone, or a polymerizable monomer, such as styrene, may be added individually or in a combination of two or more of them. When a polymerizable monomer such as styrene is added, it is preferable to further add an stabilizer such as hydroquinone, cathechol, picric acid, and molecular oxygen.

After progressing the reaction in some degree, acrylic acid or methacrylic acid is further reacted in an amount necessary for reacting with the residual epoxy groups from the above reaction. In this reaction, a part of the epoxy groups may remain not reacted. The amount of the acrylic acid or methacrylic acid used is 0.1 to 0.9 equivalent per 1 equivalent of brominated epoxy resin used, and the preferred total amount of the dibasic acid and acrylic acid or methacrylic acid is one equivalent or less. When it is necessary to accelerate the reaction, the catalysts described above may be added in an appropriate amount.

Thus obtained dibasic acid modified epoxy (meth)acrylate resin (A) has preferably a bromine content of 12 to 50 % by weight.

The thermosetting resin (B) having in its side chains an unsaturated group copolymerizable with the resin (A) is one which is obtained by polymerizing one or more compounds selected from the group consisting of acrylic acid, acrylic esters, methacrylic acid and methacrylic esters and, at need, a polymerizable monomer containing vinyl group followed by reacting the obtained polymer's main chain with an unsaturated basic acid or an ester or an anhydride of the unsaturated basic acid to introduce unsaturated groups in a form of a pendant. Due to the absence of ester bond in main chain, these resins are superior to unsaturated polyester resins in corrosion resistance and dielectric property. Among these, the preferred are those having a main chain of an acrylic copolymer, particularly those obtained by the addition reaction of maleic anhydride to styrene/2-hydroxyethyl methacrylate/n-butyl acrylate copolymer or by the addition reaction of acrylic acid or methacrylic acid to ethyl acrylate/butyl acrylate/glycidyl methacrylate copolymer.

The polymerizable monomer (C) to be used in the present invention has an unsaturated group and is in a liquid state at room temperature. The polymerizable monomer (C) is selected from the group consisting of styrene, vinyltoluene, divinylbenzene, α-methylstyrene, methacrylic acid, methacrylic esters, acrylic esters, and mixtures thereof. Particularly preferred is styrene.

The ratios of the amount of the (B) thermosetting resin having an unsaturated bond copolymerizable with (A) used and the amount of the (C) polymerizable monomer used to the amount of the (A) dibasic acid modified epoxy (meth)acrylate resin used may be determined appropriately depending on the halogen content and viscosity of the resin composition and are not particularly restricted. However, it is preferable to use 5 to 400 parts of (B) and 25 to 400 parts by weight of (C) per 100 parts by weight of (A), while maintaining the bromine content of the resin composition pareferably to 8 to 30 % by weight.

Also, the other flame retardants may be added to these resins for impregnating base materials, at need. Typical examples of such flame retardants include halogen-containing flame retardants such as hexabromocyclododecane, hexabromobenzene, polybrominated biphenyl ether, heptabromotoluene, 2,4,6-tribromophenol methacrylate, 2,4,6-tribromophenol glycidyl ether, brominated epoxy resins; and phosphoric esters such as triphenyl phosphate, tricresyl phosphate, and trimethyl phosphate. The particularly preferred flame retardants are those which can be polymerized with the thermosetting resin compositions of the present invention.

Further, antimony trioxide, antimony pentoxide, aluminum hydroxide, and the like may also be used as flame retardant. In addition to flame retardant, extenders such as clay, talc, and wollastonite may be added optionally.

The base materials which is to be impregnated with the thermosetting resin composition of the present invention include cellulosic base materials such as kraft paper and linter paper, glass base materials such as glass cloth, glass nonwoven fabric, and glass mixed paper.

When cellulosic papers are used, it is preferable to treat the cellulose papers with melamine resin or the like previous to impregnation of the resin composition.

When glass base materials are used, it is preferable to treat the glass base materials with a coupling agent such as vinyl silane previously.

Curing of the resin composition may be conducted either by a method of curing by adding an organic peroxide to the resin at room temperature or at an increased temperature, or by a method of irradiating light or electron ray with using a sensitizer or the like.

The electrical laminate obtained by impregnating a base material with the thermosetting resin composition described above has excellent heat resistance and flexibility endowed by modifying an brominated epoxy (meth)acrylate resin with a dimer of unsaturated fatty acids which have 16 to 18 carbon atoms and has excellent heat resistance. Further, because the thermosetting resin (B) has unsaturated bonds in its side chains, the produced laminate is superior to those produced by using conventional unsaturated polyester resin or the like in electrical properties, particularly in insulating resistance and dielectric property.

The present invention is described in more details referring to the following Examples. In the following description, the term "part" means "part by weight".

### EXAMPLES 1 TO 3 AND COMPARATIVE EXAMPLE 1

### REFERENTIAL EXAMPLE 1

In a flask were charged 231 parts of ESB-400 (trade name, bisphenol type brominated epoxy resin produced by Sumitomo Chemical Co., Ltd.), 83 parts of dimer acid, 3.3 parts of triethylamine, 144 parts of styrene, and 0.02 parts of hydroquinone, and the mixture was reacted at 90 to 100 °C until the acid value dropped to not higher than 6. Subsequently, 20 parts of methacrylic acid was added to the reaction mixture, and the reaction was allowed to continue until the acid value dropped to not more than 4 to obtain a dimer acid modified brominated epoxy methacrylate resin (resin (1)). (non-volatile matter: 70 %, bromine content: 23 %)

### REFERENTIAL EXAMPLE 2

The procedure of the Referential Example 1 was repeated with the exception that acrylic acid was used in place of methacrylic acid, to obtain a resin(resin (2)).

### REFERENTIAL EXAMPLE 3

The procedure of the Referential Example 1 was repeated with the exception that dimer acid was not added, and the brominated epoxy resin and the same epoxy resin not brominated were used, and an epoxy methacrylate resin (resin (3)) was obtained. (non-volatile matter: 70 %, bromine content: 23 %)

### REFERENTIAL EXAMPLE 4

Solution polymerization was carried out using, as the raw materials, 30 parts of styrene, 40 parts of 2hydroxyethyl methacrylate, and 40 parts of n-butyl acrylate and, as the solvent, methyl isobutyl ketone. Subsequently, after maleic anhydride was addition-reacted to the obtained copolymer to add side chains having double bonds, styrene was added to obtain a thermosetting resin containing 60 % of non-volatile matter (resin (4)).

### EXAMPLE 1

A kraft paper, which had been treated previously with an aqueous solution of methylol melamine (MELAN 630, produced by Hitachi Chemical Company, Ltd.), having a resin content of 14 %, a thickness of 0.25 mm, and a basic weight of 140 g was impregnated with a liquid resin blend composed of 60 parts of resin (1), 40 parts of resin (4), 5 parts of antimony trioxide, and one part of benzyl peroxide, to obtain an impregnated kraft paper having a total resin content of 70 %. After laminating six resin impregnated kraft papers followed by further laminating an electrolytic copper foil of 35 µ m thickness coated with an epoxy adhesive, the obtained laminate was cured by heating and pressing at 120 °C, under a pressure of 15 kg/cm, for 20 minutes, to obtain a copper clad laminate of 1.6 mm thickness.

### COMPARATIVE EXAMPLE 1

The procedure of the Example 1 was repeated with the exception that resin (3) and resin (5) were used in place of resin (1) and resin (5), and a copper clad laminate of 1.6 mm thickness was obtained.

### REFERENTIAL EXAMPLE 5

The procedure of the Referential Example 2 was repeated with the exception that a mixture of 189 parts of a brominated epoxy resin, SUMI-EPOXY ESB-400 (trade name, a tetrabromobisphenol A type epoxy resin), and 42 parts of a non-brominated epoxy resin (trade name: EPOMIC R-140P produced by Mitsui Petrochemical Industries, Ltd.) was used as the bromine-containing epoxy resin, and a dimer acid modified epoxy methacrylate resin (resin (5)) was obtained. (non-volatile matter: 70 % by weight, bromine content: 19 % by weight)

### EXAMPLE 2

The procedure of the Example 1 was repeated with the exception that 74 parts of resin (5) and 26 parts of resin (4) were used in place of resin (1) and resin (4), and a copper clad laminate of 1.6 mm thickness was obtained.

The results of various tests conducted on the copper clad laminates obtained in the above Examples are shown in the following Table.

**Table**

| | | Example 1 | Example 2 | Comparative Example 1 |
|---|---|---|---|---|
| Water absorption (%) E-24/50 + D-24/23 | | 0.45 | 0.48 | 0.41 |
| Insulation resistance (Ω) (D-2/100) | | 1.2 ×10¹⁰ | 5.0×10⁹ | 2.0×10¹¹ |
| Soldering heat resistance 260°C (second) | | 60 | 62 | 90 |
| Flame resistance | | V-0 | V-0 | V-0 |
| Dielectric constant | A | 3.9 | 3.9 | 3.7 |
| (1MHz) | D-48/50 | 4.6 | 4.5 | 4.3 |
| Dielectric dissipation | A | 0.0240 | 0.241 | 0.0260 |
| factor (1MHz) | D-48/50 | 0.0280 | 0.283 | 0.0289 |
| Punching quality | 20°C | Δ | Δ | X |
| | 40°C | ○ | ○~Δ | Δ~X |
| | 60°C | ○ | ○ | Δ |
| | 80°C | ○ | ○ | ○~Δ |

- Test methods: Flame resistance : UL268 & 492
Punching quality : ASTM D617-44
the others : JIS C 6481

D; dipping E; drying A; normal condition
24/50; measurement after standing at 50°C for 24 hours

## Claims

1. An electrical laminate produced by impregnating a base material with a thermosetting resin composition comprising
(A) a dibasic acid modified epoxy(meth)acrylate resin obtained by reacting a bromine-containing epoxy resin with a dimer of unsaturated fatty acids which have 16 to 18 carbon atoms followed by further reacting with acrylic acid or methacrylic acid,
(B) a thermosetting resin having a main chain of an acrylic polymer or copolymer obtained by the polymerisation of one or more compounds selected from the group consisting of acrylic acid, acrylic esters, methacrylic acid, methacrylic esters and optionally vinyl group containing monomers, said main chain containing additionally functional groups, which have been reacted with unsaturated acids, their esters or anhydrides, in order to provide the main chain with unsaturated side groups, which are copolymerizable with (A), and
(C) a polymerizable monomer, selected from the group consisting of styrene, vinyltoluene, divinylbenzene, α-methylstyrene, methacrylic acid, methacrylic esters, acrylic esters
and a mixture thereof.

2. The electrical laminate as claimed in claim 1, wherein the bromine-containing epoxy resin is a brominated epoxy resin.

3. The electrical laminate as claimed in claim 1, wherein the bromine-containing epoxy resin is a mixture of (a) a brominated epoxy resin and (b) a non-brominated epoxy resin, the mixture containing at least 25 % by weight of the brominated epoxy resin (a).

4. The electrical laminate as claimed in claim 2 or 3, wherein the brominated epoxy resin (a) is a bisphenol A type epoxy resin.

5. The electrical laminate as claimed in claim 4, wherein the bromine content of the brominated epoxy resin (a) is 15 to 55 % by weight.

6. The electrical laminate as claimed in any of claims 1 to 5, wherein 0.1 to 0.9 equivalent of the dibasic acid and 0.1 to 0.9 equivalent of acrylic acid or methacrylic acid are used per one equivalent of the bromine-containing epoxy resin, the total equivalent of the dibasic acid and acrylic acid or methacrylic acid being one equivalent or less.

7. The electrical laminate as claimed in any of claims 1 to 6, wherein the bromine content of the resin (A) is 12 to 50 % by weight.

8. The electrical laminate as claimed in any of claims 1 to 7, wherein the thermosetting resin (B) is obtained by addition reaction of maleic anhydride to a styrene/2-hydroxyethyl methacrylate/butyl acrylate copolymer.

9. The electrical laminate as claimed in any of claims 1 to 7 wherein the thermosetting resin (B) is obtained by addition reaction of acrylic acid or methacrylic acid to an ethyl acrylate/butyl acrylate/glycidyl methacrylate copolymer.

10. The electrical laminate as claimed in any of claims 1 to 9, wherein the polymerizable monomer (C) is styrene.

11. The electrical laminate as claimed in any of claims 1 to 10, wherein the thermosetting resin composition comprises 100 parts by weight of the resin (A), 5 to 400 parts by weight of the thermosetting resin (B), and 25 to 400 parts by weight of the polymerizable monomer (C), and the bromine content of the thermosetting resin composition is 8 to 30 % by weight.

## Patentansprüche

1. Elektro-Laminat, das hergestellt wird durch Imprägnieren einer Basissubstanz mit einer hitzehärtbaren Harzzusammensetzung, die
(A) ein mit einer zweiwertigen Säure modifiziertes Epoxy(meth)acrylat-Harz, das erhalten wird durch Umsetzung eines bromhaltigen Epoxyharzes mit einem Dimer ungesättigter Fettsäuren mit 16 bis 18 Kohlenstoffatomen und anschließende zusätzliche Umsetzung mit Acrylsäure oder Methacrylsäure,
(B) ein hitzehärtbares Harz mit einer Hauptkette aus einem Acryl-Polymer oder -Copolymer, das erhalten wird durch Polymerisation einer oder mehrerer Verbindungen, die aus der aus Acrylsäure, Acrylsäureestern, Methacrylsäure, Methacrylsäureestern und wahlweise Vinylgruppen enthaltenden Monomeren bestehenden Gruppe ausgewählt werden, wobei die Hauptkette zusätzlich funktionelle Gruppen enthält, die mit ungesättigten Säuren, deren Estern oder Anhyriden umgesetzt wurden, um die Hauptkette mit ungesättigten Seitengruppen zu versehen, die mit (A) copolymerisierbar sind,
(C) ein polymerisierbares Monomer, das aus der Gruppe bestehend aus Styrol, Vinyltoluol, Divinylbenzol, α-Methylstyrol, Methacrylsäure, Methacrylsäureestern, Acrylsäureestern und Mischungen davon ausgewählt wird, umfaßt.

2. Elektro-Laminat gemäß Anspruch 1, worin das bromhaltige Epoxyharz ein bromiertes Epoxyharz ist.

3. Elektro-Laminat gemäß Anspruch 1, worin das bromhaltige Epoxyharz eine Mischung (a) eines bromierten Epoxyharzes und (b) eines nicht bromierten Epoxyharzes ist, wobei die Mischung mindestens 25 Gew.-% des bromierten Epoxyharzes (a) enthält.

4. Elektro-Laminat gemäß Anspruch 2 oder 3, worin das bromierte Epoxyharz (a) ein Epoxyharz vom Bisphenol A-Typ ist.

5. Elektro-Laminat gemäß Anspruch 4, worin der Bromgehalt des bromierten Epoxyharzes (a) 15 bis 55 Gew.-% beträgt.

6. Elektro-Laminat gemäß einem der Ansprüche 1 bis 5, worin 0,1 bis 0,9 Äquivalent der zweiwertigen Säure und 0,1 bis 0,9 Äquivalent der Acrylsäure oder Methacrylsäure pro ein Äquivalent des bromhaltigen Epoxyharzes verwendet werden, wobei die Äquivalent-Summe der zweiwertigen Säure und Acrylsäure oder Methacrylsäure ein Äquivalent oder weniger beträgt.

7. Elektro-Laminat gemäß einem der Ansprüche 1 bis 6, worin der Bromgehalt des Harzes (A) 12 bis 50 Gew.-% beträgt.

8. Elektro-Laminat gemäß einem der Ansprüche 1 bis 7, worin das hitzehärtbare Harz (B) erhalten wird durch Additionsreaktion von Maleinsäureanhydrid mit einem Styrol/2-Hydroxyethylmethacrylat/Butylacrylat-Copolymer.

9. Elektro-Laminat gemäß einem der Ansprüche 1 bis 7, worin das hitzehärtbare Harz (B) erhalten wird durch Additionsreaktion von Acrylsäure oder Methacrylsäure mit einem Ethylacrylat/Butylacrylat/Glycidylmethacrylat-Copolymer.

10. Elektro-Laminat gemäß einem der Ansprüche 1 bis 9, worin das polymerisierbare Monomer (C) Styrol ist.

11. Elektro-Laminat gemäß einem der Ansprüche 1 bis 10, worin die hitzehärtbare Harzzusammensetzung 100 Gew.-Teile des Harzes (A), 5 bis 400 Gew.-Teile des hitzehärtbaren Harzes (B) und 25 bis 400 Gew.-Teile des polymerisierbaren Monomers (C) enthält, und der Bromgehalt der hitzehärtbaren Harzzusammensetzung 8 bis 30 Gew.-% beträgt.

## Revendications

1. Stratifié électrique fabriqué en imprégnant une matière de base avec une composition de résine thermodurcissable comprenant
(A) une résine époxy(méth)acrylate modifiée par un acide dibasique obtenue en faisant réagir une résine époxyde contenant du brome avec un dimère d'acides gras insaturés ayant de 16 à 18 atomes de carbone, puis en faisant encore réagir avec de l'acide acrylique ou de l'acide méthacrylique,
(B) une résine thermodurcissable ayant une chaîne principale de polymère ou copolymère acrylique obtenue par polymérisation d'un ou plusieurs composés choisis dans le groupe constitué par l'acide acrylique, les esters acryliques, l'acide méthacrylique, les esters méthacryliques et facultativement des monomères contenant un groupe vinyle, ladite chaîne principale contenant en outre des groupes fonctionnels, que l'on a fait réagir avec des acides insaturés, leurs esters ou anhydrides, afin de munir la chaîne principale de groupes latéraux insaturés, qui sont copolymérisables avec (A), et
(C) un monomère polymérisable, choisi dans le groupe constitué par le styrène, le vinyltoluène, le divinylbenzène, l'α-méthylstyrène, l'acide méthacrylique, les esters méthacryliques, les esters acryliques et un de leurs mélanges.

2. Stratifié électrique selon la revendication 1, dans lequel la résine époxyde contenant du brome est une résine époxyde bromée.

3. Stratifié électrique selon la revendication 1, dans lequel la résine époxyde contenant du brome est un mélange de (a) une résine époxyde bromée et (b) une résine époxyde non bromée, le mélange contenant au moins 25 % en poids de la résine époxyde bromée (a).

4. Stratifié électrique selon la revendication 2 ou 3, dans lequel la résine époxyde bromée (a) est une résine époxyde de type bisphénol A.

5. Stratifié électrique selon la revendication 4, dans lequel la teneur en brome de la résine époxyde bromée (a) est de 15 à 55 % en poids.

6. Stratifié électrique selon l'une quelconque des revendications 1 à 5, dans lequel on utilise de 0,1 à 0,9 équivalent de l'acide dibasique et de 0,1 à 0,9 équivalent d'acide acrylique ou d'acide méthacrylique pour un équivalent de la résine époxyde contenant du brome, l'équivalent total de l'acide dibasique et de l'acide acrylique ou de l'acide méthacrylique étant d'un équivalent ou moins.

7. Stratifié électrique selon l'une quelconque des revendications 1 à 6, dans lequel la teneur en brome de la résine (A) est de 12 à 50 % en poids.

8. Stratifié électrique selon l'une quelconque des revendications 1 à 7, dans lequel on obtient la résine thermodurcissable (B) par une réaction d'addition de l'anhydride maléique à un copolymère styrène/méthacrylate de 2-hydroxyéthyle/acrylate de butyle.

9. Stratifié électrique selon l'une quelconque des revendications 1 à 7, dans lequel on obtient la résine thermodurcissable (B) par une réaction d'addition d'acide acrylique ou d'acide méthacrylique à un copolymère acrylate d'éthyle/acrylate de butyle/méthacrylate de glycidyle.

10. Stratifié électrique selon l'une quelconque des revendications 1 à 9, dans lequel le monomère polymérisable (C) est le styrène.

11. Stratifié électrique selon l'une quelconque des revendications 1 à 10, dans lequel la composition de résine thermodurcissable comprend 100 parties en poids de la résine (A), de 5 à 400 parties en poids de la résine thermodurcissable (B), et de 25 à 400 parties en poids du monomère polymérisable (C), et la teneur en brome de la composition de résine thermodurcissable est de 8 à 30 % en poids.
